# EUROPEAN PATENT SPECIFICATION

(11) **EP 4 043 627 B1**
(45) Date of publication and mention of the grant of the patent: **18.10.2023**
(21) Application number: 21156315.0
(22) Date of filing: 10.02.2021
(51) Int. Cl.: D02G 3/44, D03D 11/00, D03D 15/533, D03D 13/00, A41D 13/008

(54) **ELECTROMAGNETIC SHIELDING FABRIC**
ELEKTROMAGNETISCH ABSCHIRMENDES GEWEBE
TISSU DE BLINDAGE ÉLECTROMAGNÉTIQUE

(43) Date of publication of application: 17.08.2022
(73) Proprietor: Backhausen GmbH, 3945 Hoheneich (AT)
(72) Inventor: Kiesling, Louise, 3400 Klosterneuburg (AT); Mandel, Jürgen, 3945 Hoheneich (AT); Bauer, Mario, 3945 Hoheneich (AT)
(74) Representative: Mati, Silvia

(56) References cited:
- CN-A- 105 483 906
- DE-T2- 60 216 062
- JP-A- 2005 179 849

## Description

### TECHNICAL FIELD

The present invention refers to the field of textiles. Particularly, the present invention relates to an electromagnetic shielding fabric.

### STATE OF THE ART

Electronic devices capable of exchanging data with one another via radiofrequency communications are widespread. Particularly, in the case of Wireless Wide Area Networks (WWANs) and Wireless Local Area Networks (WLANs) - such as GSM, UMTS, LTE/LTE-A, 5G, WiFi, WIMAX telecommunication networks - data is constantly transmitted among devices via radiofrequency transmissions in various frequency bands and with various energies. Moreover, also short-range communication standards, such as Bluetooth and Zigbee, are widely used to wirelessly connect various devices.

Particularly in the case of urban environments, each corner of the human environment is continuously permeated by electromagnetic radiations carrying a large amount of energy spread over a large frequency spectrum.

This radio frequency crowding can cause interference problems and reduce the efficiency of the communications. In addition, the long-term effects of a continuous exposure to electromagnetic radiations on human beings are not yet fully known.

Furthermore, wireless connectivity gives the opportunity to an illegal access to data or to infiltrate/hijack a wireless device or an entire computer network remotely, i.e. within a range in which the wireless signals are successfully transmitted/received by the target device/s (e.g., in the order of tens of meters for WiFi signals and hundreds of meter for GSM signals).

From the above, the need for a solution able to, at least partially, shield a person or a space - e.g., a window, a room of a building, a cabin of a vehicle, *etc.* - from electromagnetic radiation in a simple and effective manner becomes evident.

To this extent, textiles or fabrics comprising metal threads arranged to provide an electromagnetic radiation shielding based on the so-called Faraday Cage effect have been proposed in the art.

For example, CN 105483906 discloses a composite fabric formed by combining various materials. In a warp-direction, bamboo fibers and cotton/stainless-steel fibers are used. The bamboo fibers and the cotton/stainless-steel fibers are arranged in a 5:1 ratio. In a weft-direction, a surface layer comprises cotton/stainless-steel fibers, while a lining layer uses modal fibers. The surface layer and the lining layer are arranged in a 1:1 ratio. The surface layer adopts two-up one-down twill in the warp direction as a surface, a fluffy and soft towel structure is used as a base of the lining layer. The cotton/ stainless-steel fibers in the front of the surface layer are interwoven in warp and weft directions to form a net-shaped structure, to provide electromagnetic radiation shielding and antistatic performance.

CN 201704490 discloses a dual antibacterial radiation-proof fabric, which comprises a plurality of warp and weft strands, the warp strands include bamboo and metal fiber strands, which are arranged alternately. Each weft strand consists of a metal fiber strand and a bamboo fiber strand arranged on the upper surface of the metal fiber strand, and the weft strands is sequentially guided beneath a first warp strand of a group of four warp strands arranged side by side and then above the other three warp strands.

DE 60216062 discloses a reinforced fabric. The reinforced fabric comprises on its front side a bond of warp threads and weft threads or a mesh-like binding comprising a reinforcement grid of warp and weft threads on its back. The warp and weft threads of the reinforced grid are made of a material which has higher mechanical properties than warp and weft threads with which the front side is made. The reinforcing grid is connected to the front side by its warp threads and weft threads, the warp threads and the weft threads are attached at different points on the front and cross each other outside of the base fabric forming the front.

The Applicant has found that the conductive threads of these fabrics have a nonuniform grid structure. Particularly, crossing points between weft and warp threads are not regularly spaced apart and/or the weft and warp threads result only loosely set on top of each other, which does not guarantee a reliable contact. Moreover, the contact between conductive warp and weft threads results to be influenced by a shape of a surface that the fabric covers, or by any fold that may be produced during use.

These drawbacks have the effect to break the regularity of the grid structure of the conductive threads in the fabric and, accordingly, prevent the fabrics from providing a constant and homogeneous shielding effect.

In addition, the Applicant has found that the electromagnetic shielding fabrics known in the art do not allow weaving complex patterns while maintaining a regular grid structure. In other words, the fabric known in the art are 'functional' fabrics that are not suited for manufacturing products that also meet the essentials of fashion and interior design industry.

### SUMMARY OF THE INVENTION

It is an object of the present invention to overcome the drawbacks of the prior art.

Particularly, the present invention aims to provide a fabric where functionality does not conflict with design. In other words, the present invention is directed to a fabric capable of providing an effective electromagnetic radiation shielding and, at the same time, characterized by minimal visual and physical limitations, to make it possible to weave a large variety of designs.

It is a further object of the present invention to provide a fabric comprising an effective electromagnetic shielding grid and, at the same time, an aesthetic patterned surface in which the conductive threads forming the electromagnetic shielding grid are imperceptible or cannot substantially be perceived by a user. These and further objects of the present invention will become clear from the following description and from the appended claims, which form an integral part of the present description.

According to a first aspect, the invention relates to a fabric comprising:
- a non-conductive woven layer, comprising a plurality of non-conductive warp threads and a plurality of non-conductive weft threads, both the non-conductive warp threads and the non-conductive weft threads being made of a non-conductive material, and
- a conductive woven layer, comprising a plurality of conductive warp threads and a plurality of conductive weft threads, both the conductive warp threads and the conductive weft threads being at least partially made of an electrically conductive material.

In detail, the non-conductive woven layer defines a patterned surface of the fabric and the conductive woven layer defines a grid-like structure, the non-conductive woven layer and the conductive woven layer being interwoven together. Moreover, wherein the fabric comprises a plurality of sectors arranged adjacent one another in a warp direction and/or in a weft direction, each sector comprising at least one group of non-conductive warp threads and one conductive warp thread, and at least one group of non-conductive weft threads and one conductive weft thread. The group of non-conductive warp threads comprises at least two non-conductive threads, and the group of non-conductive weft threads comprises at least one non-conductive thread.

According to the invention, each sector further comprises:
- a first binding point in which the conductive warp thread is lowered beneath the conductive weft thread, and
- a second binding point for each non-conductive warp thread of the group of non-conductive warp threads, in which the non-conductive warp thread is lifted above the conductive weft thread.

Moreover, according to the invention, alternating sectors along the warp direction and/or the weft direction comprise:
- a third binding point in which the conductive warp thread is lifted above at least one non-conductive weft thread of the group of non-conductive weft threads, the third binding point being adjacent to the first binding point in which the conductive warp thread is lowered beneath the conductive weft thread.

Within the scope of the present description and in the appended claims, the term 'conductive' implies the property of a material to be crossed by a flow of electrical current, while the term 'non-conductive' implies the property of a material to hinder a flow of electrical current therethrough. Particularly, 'conductive threads' are characterized by an electrical resistivity which is significantly lower than an electrical resistivity of 'non-conductive threads'. For example, non-conductive threads have a resistivity that is three or more orders of magnitude larger than that of conductive threads.

The Applicant realized that the fabric according to the invention as defined above provides an excellent electromagnetic shielding over a very large frequency spectrum. With 'excellent electromagnetic shielding' it is meant the effect of reducing the energy associated with an electromagnetic radiation measured downstream of the fabric to a value which is 1% or below of the energy measured upstream of the textile.

In other words, a body covered by a fabric according to the present invention is protected from being reached by electromagnetic radiation having an energy level which has been proven to be harmful for human beings and/or sufficient to perform a wireless communication.

Particularly, the fabric according to the invention as defined above effectively shields from electromagnetic radiations having frequencies comprised in the frequency bands used substantially by all the wireless communication systems, such as cellular networks (e.g., GSM, UMTS, LTE/LTE-A, 5G), WLANs (e.g., WiFi, WIMAX), short range communications system and personal area networks (e.g., Bluetooth, Zigbee). More generally, the fabric according to the present invention as defined above effectively shields from electromagnetic radiation in the Very high frequency (VHF), Ultra high frequency (UHF), and Super high frequency (SHF) ranges, and at least partly in the Extremely high frequency (EHF) range.

As designated by the International Telecommunication Union (ITU), VHF covers radio frequencies ranging from 30 MHz to 300 MHz, UHF covers radio frequencies ranging from 300 MHz to 3 GHz, SHF covers radio frequencies ranging from 3 GHz to 30 GHz, and EHF covers radio frequencies ranging from 30 GHz to 300 GHz.

At the same time, the non-conductive woven layer can be woven to obtain aesthetic patterns, even of high complexity. In fact, the conductive warp and weft threads are imperceptible on the non-conductive woven layer, while the conductive woven layer is structured as a uniform and regular grid-like structure.

Particularly, the inventive binding developed by the Applicant leads to two interwoven layers of fabric. At the same time, the conductive warp and weft threads are in constant contact - both mechanical and electrical - regularly along the weft and warp directions of the fabric. This ensures that the grid-like structure remains substantially unaltered when the fabric is folded or stretched during its use, thus providing a reliable electromagnetic shielding in many applications and conditions.

Moreover, the specific structure of the fabric according to the invention having a group of non-conductive warp threads comprising at least two non-conductive threads, and a group of non-conductive weft threads comprising at least one non-conductive thread in each sector of the fabric allows implementing a wide variety of aesthetic patterns, e.g. by using the Jacquard weaving technique.

In an embodiment, the group of non-conductive warp threads comprises three non-conductive weft threads. Preferably, the alternating sectors along the warp direction and/or the weft direction comprise a single third binding point in which the conductive warp thread is lifted above the at least one non-conductive weft thread.

The Applicant has found that this particular binding between conductive and non-conductive warp and weft threads substantially allows obtaining any desired pattern on the non-conductive woven layer and, at the same time, a very fine and reliable grid-like structure in the conductive woven layer that provides remarkable electromagnetic shielding over the frequency spectrum mentioned above.

In an embodiment, the group of non-conductive weft threads comprises at least four non-conductive weft threads. Preferably, each sector comprises at least one further third binding point in which the conductive warp thread is lifted above at least one non-conductive weft thread. Advantageously, each further third binding point is spaced apart by at least three non-conductive weft threads from a preceding first binding point and/or third binding point along the warp direction.

This arrangement of the bindings allows maintaining the conductive woven layer structure firmly bonded to the non-conductive woven layer and a regular grid-like structure during the use of the fabric, even for fabrics comprising a large number of non-conductive warp and/or weft threads.

In an embodiment, each first binding point is spaced apart from the first binding point of another sector by a distance ranging from 1.5 mm to 3.5 mm, preferably equal to 2 mm, in the weft direction and/or the warp direction, preferably in both the weft and the warp direction.

Preferably, each sector comprises conductive warp threads and non-conductive warp threads in a ratio selected among 1:3, 1:5, 1:7, and 1:9.

The Applicant has found that these specific ratios between warp and weft threads provide the best results in terms of pattern design and electromagnetic shielding.

In an embodiment, the conductive warp threads and the conductive weft threads are made of yarns obtained by spinning metal fibers, preferably stainless-steel fibers, with natural fibers in a ratio ranging from 5% to 50% of metal fibers (e.g., stainless-steel fibers), preferably equal to 20% of metal fibers (e.g., stainless-steel fibers).

In a preferred embodiment, the conductive warp threads and the conductive weft threads are made of yarns obtained by spinning stainless-steel fibers with wool.

The conductive warp and weft threads with this composition allow both realizing an effective faraday cage and dyeing the threads. Accordingly, a vast variety of aesthetic patterns may be woven. Moreover, the above composition revealed to be optimal to hide the presence of the metal fibers in the fabric according to the invention. In other words, the above composition allows minimizing color alteration (greying) and/or metallic shimmer usually connected with the presence of metal fibers in a fabric.

Furthermore, the Applicant has found that conductive threads made of stainless-steel possess advantages over other conducting materials such as silver or copper. Particularly, stainless-steel is both dermatologically safe and corrosion resistant. Accordingly, the threads can interact with the human skin without provoking negative reactions and can sustain wear and chemical treatment. The resulting threads are, thus, safe for human use and have stable appearance throughout a long useful life.

In an embodiment of the invention, the conductive warp threads and the conductive weft threads have a yarn count or linear density ranging from 12.5 tex (g/km) to 125 tex (g/km).

Particularly, the yarn count - also known as 'weight numbering' - provides an indication of the weight per length of a yarn or thread. In detail, the unit for the yarn count is the 'tex', which corresponds to one gram per one thousand meters in units of the International System of measurements - i.e., 1tex = 1g/1km

Preferably, each one of the conductive warp threads and the conductive weft threads is made of one or more yarns having a fineness ranging from 8 m/g to 50 m/g, indicated as 8 Nm and 50 Nm, respectively, in the industry.

Particularly, the 'fineness' is a feature of a thread that is defined as the length of a thread per unit of weight. The unit for the fineness is the 'Numbering', or Nm, which corresponds to one meter per one gram in units of the International System of measurements - i.e., 1Nm = 1m/1g

More preferably, each one of the conductive warp threads and the conductive weft threads comprises 2 yarns, each of which has a fineness equal to 50 m/g (indicated as 50/2 Nm in the industry).

The Applicant has found that this structure ensures reliable mechanical and electrical properties of the conductive threads, which allow an easy weaving in combination with non-conductive threads.

In an embodiment, each non-conductive warp thread comprises two yarns, each of which is made of wool and has a fineness equal to 60 m/g (indicated as 60/2 Nm in the industry). Furthermore, each non-conductive weft thread comprises two yarns, each of which is made of wool and has a numbering equal to 28 m/g (indicated as 28/2 Nm in the industry).

These features of the threads allow obtaining a high-quality fabric suitable for manufacturing products that meet the needs of the fashion and interior design industry.

A different aspect of the present invention relates to a multi-sheet fabric. The multi-sheet fabric comprises at least two sheets of fabrics according to one of the above embodiments. Advantageously the two fabric sheets are sewn together. The multi-sheet fabric provides a greater electromagnetic shielding than a single sheet fabric. Moreover, in case both the two outermost fabric sheets of the multi-sheet fabric are sewn together with the patterned surface facing the external environment, the grid like structure is completely hidden from the view.

A further different aspect of the present invention relates to a method of manufacturing an electromagnetic shielding fabric. The electromagnetic shielding fabric comprises:
- a non-conductive woven layer, comprising a plurality of non-conductive warp threads and a plurality of non-conductive weft threads, both the non-conductive warp threads and the non-conductive weft threads being made of a non-conductive material, and
- a conductive woven layer, comprising a plurality of conductive warp threads and a plurality of conductive weft threads, both the conductive warp threads and the conductive weft threads being at least partially made of an electrically conductive material.

The non-conductive woven layer defines a patterned surface of the fabric and the conductive woven layer defines a grid-like structure, the non-conductive woven layer and the conductive woven layer being interwoven together.

The method comprising the step of weaving the fabric by defining a plurality of sectors arranged adjacent one another in a warp direction and/or in a weft direction. Particularly, each sector comprises at least one group of non-conductive warp threads and one conductive warp thread, and at least one group of non-conductive weft threads and one conductive weft thread. The group of non-conductive warp threads comprises at least two non-conductive threads, and the group of non-conductive weft threads comprises at least one non-conductive thread.

According to the invention, the step of weaving the fabric by defining a plurality of sectors comprises, in each sector:
- lowering the conductive warp thread beneath the conductive weft thread at a first binding point, and
- lifting each non-conductive warp thread of the group of non-conductive warp threads above the conductive weft thread at respective second binding points, and in alternating sectors along the warp direction and/or the weft direction:
- lifting the conductive warp thread above at least one non-conductive weft thread of the group of non-conductive weft threads at a third binding point, the third binding point being weaved adjacent to the first binding point.

In an embodiment, the group of non-conductive warp threads comprises three non-conductive warp threads.

In this case, the step of lifting the conductive warp thread above at least one non-conductive weft thread of the group of non-conductive weft threads at a third binding point comprises: lifting the conductive warp thread in a single third binding point in each sector.

In a different embodiment, the group of non-conductive weft threads comprises at least four non-conductive weft threads. In this case, the step of lifting the conductive warp thread above at least one non-conductive weft thread of the group of non-conductive weft threads at a third binding point comprises: lifting the conductive warp thread above a plurality of non-conductive weft threads at respective third binding points. Particularly, each third binding point is spaced apart by at least three non-conductive weft threads from a preceding third binding point along the warp direction.

Further features and advantages of the present invention will become apparent from the following detailed description of some preferred embodiments thereof depicted in the appended drawings.

### BRIEF DESCRIPTION OF THE DRAWINGS

The invention will be described below with reference to some exemplary and non-limiting embodiments shown in the annexed drawings related to different aspects of the present invention.
Figure 1 is a portion of a fabric according to an embodiment of the present invention, partly folded in order to show both sides thereof;
Figure 2a is a portion of a binding pattern of a fabric according to a first embodiment of the present invention;
Figure 2b is a detail of a first sector of the fabric of Figure 2a highlighting a first binding scheme of conductive warp and weft threads of the fabric;
Figure 2c is a detail of a second sector of the fabric of Figures 2a highlighting a second binding scheme of conductive warp and weft threads of the fabric;
Figure 3a is a portion of a binding pattern of a fabric according to a second embodiment of the present invention;
Figure 3b is a detail of a first sector the fabric of Figure 3a highlighting a first binding scheme of conductive warp and weft threads of the fabric;
Figure 3c is a detail of a second sector the fabric of Figure 3a highlighting a binding scheme of a second conductive warp and weft threads of the fabric;
Figures 4a and 4b are plots of electromagnetic shielding as a function of the frequency of the electromagnetic radiations provided by a first sample of fabric according to an embodiment of the invention;
Figures 5a and 5b are plots of electromagnetic shielding as a function of the frequency of the electromagnetic radiations provided by a second sample of a shielding fabric which is not an embodiment of the present invention, and
Figures 6a and 6b are plots of electromagnetic shielding as a function of the frequency of the electromagnetic radiations provided by a third sample of a further shielding fabric, which is not an embodiment of the present invention.

### DETAILED DESCRIPTION OF THE INVENTION

While the invention can be implemented in several alternative ways, some preferred embodiments are shown in the drawings and will be described in detail in the following. It should be understood, however, that there is no intention to limit the invention to the specific disclosed embodiments but, on the contrary, the invention intends to cover all the modifications, alternative constructions and equivalents that fall within the scope of the invention as defined in the claims.

The use of "for example", "etc.", "or" denotes non-exclusive alternatives without limitation, unless otherwise noted. The use of "includes" means "includes, but not limited to", unless otherwise noted.

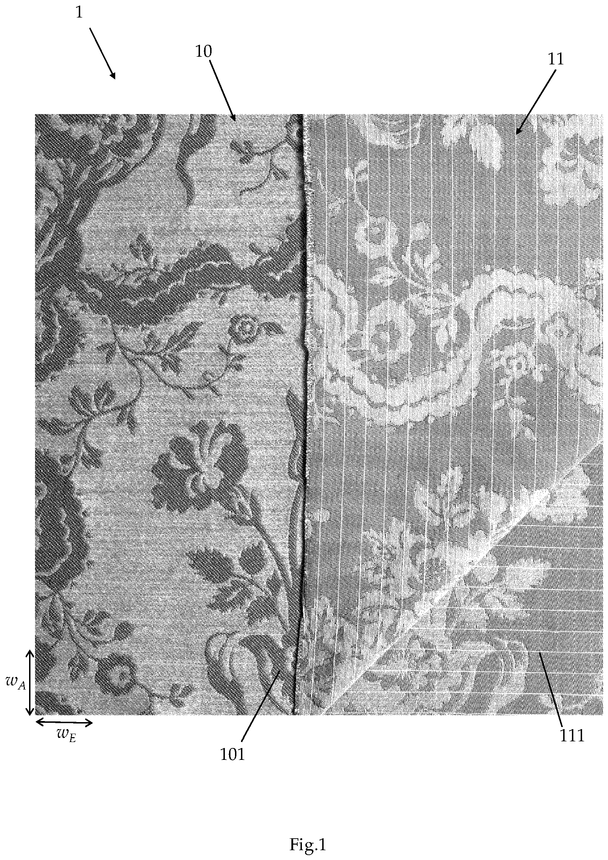

Figure 1 shows a piece of textile or fabric 1 according to an embodiment of the present invention, which comprises an aesthetic patterned surface 10 and an opposed second, shielding, surface 11. In detail, a non-conductive woven layer forms the patterned surface 10 and is interwoven to a conductive woven layer which forms the shielding surface 11.

The non-conductive woven layer comprises a plurality of warp and weft threads woven in a pattern that is designed to reproduce a desired figure 101 on the patterned surface 10. Usually, the figure 101 is repeated periodically along a warp direction *ω_{A}* and/or a weft direction *ω_{E}* along the patterned surface 10.

The warp threads and the weft threads of the non-conductive woven layer are made of a non-conductive material. In the following, the warp threads and the weft threads of the non-conductive woven layer will be referred to as 'non-conductive' warp threads and 'non-conductive' weft threads, respectively.

Preferably, the non-conductive warp threads and the non-conductive weft threads of the non-conductive layer are made of a natural fiber, more preferably wool.

In the field of textiles, threads can be categorized based on the 'fineness' that is the length of a thread per unit of weight. The unit of measurement for the fineness is the 'Numbering', or Nm, which corresponds to one meter per one gram in units of the International System of measurements - i.e., 1Nm = 1m/1g.

In the embodiments of the present invention, the non-conductive warp threads are wool threads having a fineness of 60/2 Nm - i.e. each thread comprises 2 yarns, each of which has a fineness of 60 m/g -, while the non-conductive weft threads are wool threads having a fineness of 28/2 Nm - i.e. each thread comprises 2 yarns, each of which has a fineness of 28 m/g. More generally, the non-conductive warp and weft threads have a fineness ranging from 8/1 Nm to 50/1 Nm.

The conductive woven layer comprises a plurality of warp and weft threads woven in a grid-like pattern 111 designed to create a so-called Faraday cage. Particularly, the grid-like pattern 111 of the conductive layer comprises warp threads and weft threads spaced apart one from another in a regular and uniform manner both in the warp direction *ω_{A}* and in the weft direction *ω_{E}* along the shielding surface 11.

The warp threads and the weft threads of the conductive woven layer are made of an electrically conductive material. In the following, the warp threads and the weft threads of the conductive woven layer will be referred to as 'conductive' warp threads and 'conductive' weft threads.

Preferably, the conductive warp threads and the conductive weft threads of the conductive layer are made of a mix of a natural fiber, more preferably wool, and of a metal, more preferably stainless-steel. Advantageously, the conductive warp and weft threads are made of yarns spun from wool and stainless-steel fibers. Preferably, the conductive warp and weft threads are made of yarns spun from metal and natural fibers in a ratio ranging from 5% to 50% of metal fibers, preferably equal to 20% of metal fibers. In the example at issue the metal fibers are stainless-steel fibers.

For example, the conductive warp threads and the conductive weft threads have a yarn count ranging from 12.5 tex (i.e., 12.5 g/km) to 125 tex (125 g/km).

Preferably, the conductive warp and weft threads are threads made of a mix of wool and stainless-steel fibers and have a fineness of 50/2 Nm - i.e. each thread comprises 2 yarns, each of which has a fineness of 50 m/g.

The fabric 1 is woven in such a manner that the non-conductive and the conductive woven layer are firmly interwoven one to the other, the grid-like pattern 111 has a substantially homogeneous and regular structure and, at the same time, the conductive warp and weft threads are invisible or cannot substantially be seen by an observer on the patterned surface 10.

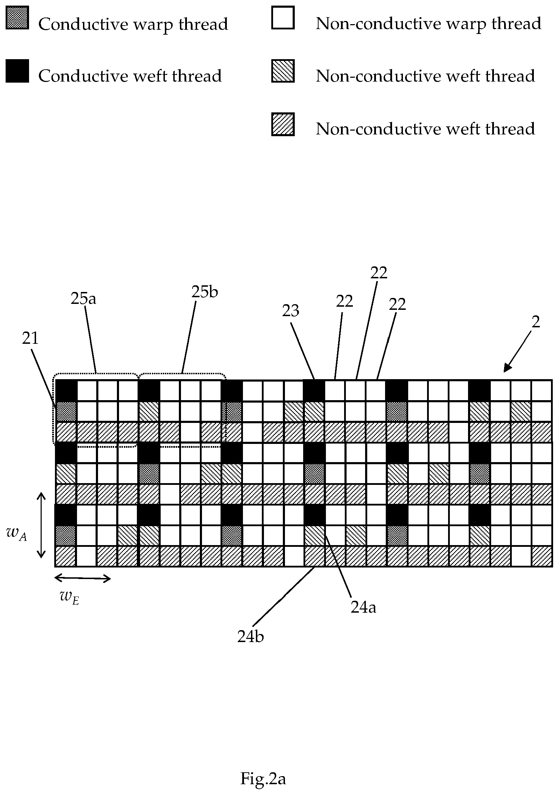

Turning to Figure 2a, a portion of a binding pattern 2 according to a first embodiment of the present invention, is shown. Particularly, the binding pattern 2 corresponds to the weaving pattern as observable on the patterned surface 10 of the fabric 1.

The binding pattern 2 comprises a plurality of conductive warp threads 21 and non-conductive warp threads 22, arranged across the weft direction *ω_{E}* according to a regular scheme. Particularly, the conductive warp threads 21 and the non-conductive warp threads 22 are arranged according to a periodic structure comprising a conductive warp thread 21 and three non-conductive warp threads 22, i.e., a conductive/non-conductive warp threads ratio equal to 1:3.

Analogously, the binding pattern 2 comprises a plurality of conductive weft threads 23 and non-conductive weft threads 24a, 24b, arranged across the warp direction *ω_{A}* according to a regular scheme. Particularly, the conductive weft threads 23 and the non-conductive weft threads 24a, 24b are arranged according to a periodic structure comprising a conductive weft thread 23 and two non-conductive weft threads 24a, 24b, i.e. a conductive/non-conductive weft threads ratio equal to 1:2. Advantageously, the non-conductive weft threads 24a, 24b generally have a different dying.

The binding pattern 2 can be subdivided into a plurality of sectors 25a, 25b each comprising a plurality of binding points. Wherein 'binding point' denotes a point, in which a warp thread crosses a weft thread, by passing above or below thereto. In the example at issue, each sector 25a, 25b comprises a set of twelve binding points between a set of four warp threads and a set of three weft threads. Particularly, each set of warp threads comprises one conductive warp thread 21 and three non-conductive warp threads 22, while each set of weft threads comprises one conductive weft threads 23 and two non-conductive weft threads 24a, 24b.

The sectors 25a, 25b are arranged adjacent one another in the warp direction *ω_{A}* and in the weft direction *ω_{E}.* In the example at issue, the plurality of sectors 25a, 25b can be divided into two sector groups. In particular, the conductive warp thread 21 and weft thread 23 in the sectors 25a pertaining to a first sector group are woven according to a first binding scheme, while the conductive warp thread 21 and weft thread 23 in the sectors 25b pertaining to a second sector group are woven according to a second binding scheme.

Moreover, the sectors 25a of the first sector group and the sectors 25b of the second sector group are arranged alternately across the warp direction *ω_{A}* and the weft direction *ω_{E},* namely along each direction, the sectors pertaining to one sector group alternate with sectors pertaining to the other group.

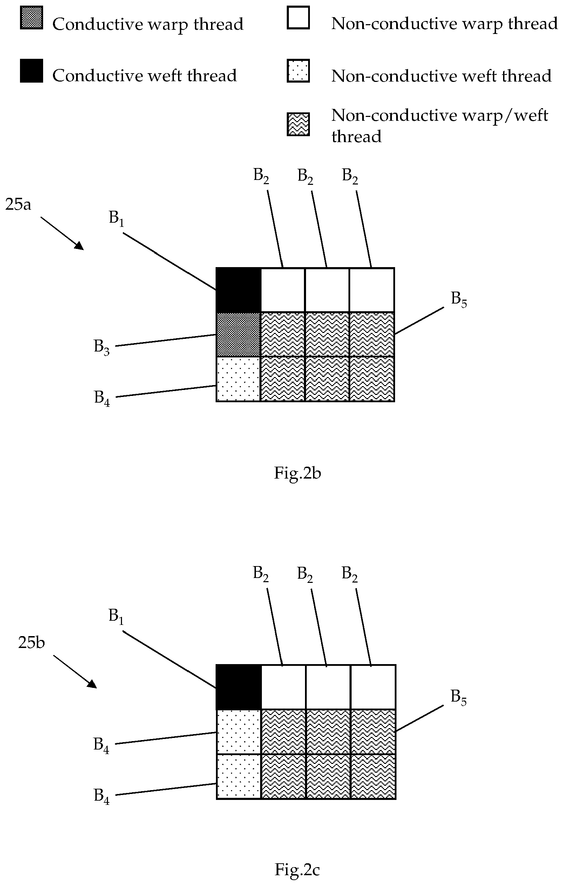

Figure 2b shows the first binding scheme used to weave the conductive warp thread 21 and weft thread 23 in the sector 25a of the first sector group. The first binding scheme comprises a single first binding point B₁ (solid black), in which the conductive warp thread 21 is lowered beneath the conductive weft thread 23. Furthermore, the first binding scheme comprises a second binding point B₂ (solid white) for each non-conductive warp thread 22, in which the non-conductive warp thread 22 is lifted above the conductive weft thread 23. Moreover, the first binding scheme comprises a single third binding point B₃ (finely dotted) in which the conductive warp thread 21 is lifted above one non-conductive weft 24a, while the conductive warp thread 21 is lowered beneath the other non-conductive weft thread 24b in a respective binding point B₄ (sparsely dotted). The single third binding point B₃ is adjacent to the single first binding point B₁ of the sector 25a.

In the remaining binding points B₅ (zigzag patterned), the non-conductive warp thread 22 can be lifted or lowered to reproduce a desired aesthetic design on the patterned surface 10.

The second binding scheme - shown in Figure 2c - corresponds to the first scheme but without the third binding point B₃. In other words, the second binding scheme comprises a single first binding point B₁ (solid black), in which the conductive warp thread 21 is lowered beneath the conductive weft thread 23. Furthermore, the second binding scheme comprises a second binding point B₂ (solid white) for each non-conductive warp thread 22 in which the non-conductive warp thread 22 is lifted above the conductive weft thread 23. Moreover, the conductive warp thread 21 is also lowered beneath the non-conductive weft threads 24a, 24b in respective binding points B₄ (sparsely dotted). In the remaining binding points B₅ (zigzag patterned), the non-conductive warp thread 22 can be lifted or lowered to reproduce an aesthetic design on the patterned surface 10.

The Applicant has found that this particular binding pattern - i.e., the first and second binding schemes arranged in an alternating manner along the warp *ω_{A}* and weft directions *ω_{E}* - allows designing a wide variety of different aesthetic patterns on the patterned surface 10, even of high complexity. Moreover, the conductive warp threads 21 and the conductive weft threads 23 are invisible or cannot substantially be perceived on the patterned surface 10, thus they do not affect the quality of the design on the patterned surface 10. At the same time, the grid-like pattern 111 has a uniform and regular structure with the conductive warp threads 21 and the conductive weft threads 23 that comprise regular and uniform contact points - both mechanical and electrical - along the weft and warp directions of the fabric.

In addition, the patterned surface 10 and the shielding surface 11 of the fabric 1 according to the invention are firmly joined together along the weft and warp directions of the fabric by interweaving. This ensures that the grid-like structure is substantially unaltered when the fabric is folded or stretched during it use, thus providing a reliable electromagnetic shielding in many applications.

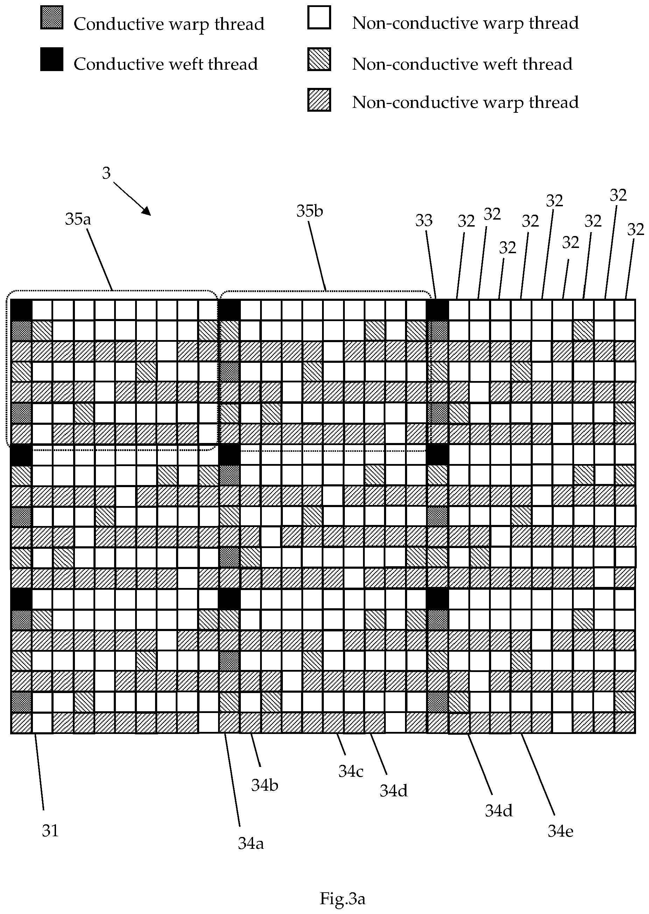

Turning to Figure 3a a portion of a binding pattern 3 according to a second embodiment of the present invention is shown. Particularly, the binding pattern 3 corresponds to the weaving pattern as observable on the patterned surface 10 of the fabric 1.

The binding pattern 3 comprises a plurality of conductive warp threads 31 and non-conductive warp threads 32, arranged across the weft direction *ω_{E}* according to a regular scheme. Particularly, the conductive warp threads 31 and the non-conductive warp threads 32 are arranged according to a periodic structure comprising a conductive warp thread 31 and nine non-conductive warp threads 32, i.e., a conductive/non-conductive warp threads ratio equal to 1:9.

Analogously, the binding pattern 3 comprises a plurality of conductive weft threads 33 and non-conductive weft threads 34a - 34g, arranged across the warp direction *ω_{A}* according to a regular scheme. Particularly, the conductive weft threads 33 and the non-conductive weft threads 34a - 34g are arranged according to a periodic structure comprising a conductive weft thread 33 and six non-conductive weft threads 34a - 34f, i.e. a conductive/non-conductive weft threads ratio equal to 1:6. Advantageously, the non-conductive weft threads 34a - 34f generally have two or more different dying in order to provide a multicolored aesthetic design on the patterned surface 10.

The binding pattern 3 can be subdivided into a plurality of sectors 35a, 35b of possible binding points between warp and weft threads. Accordingly, each sector 35a, 35b comprises a set of seventy binding points between a set of ten warp threads and a set of seven weft threads. Particularly, each set of warp threads comprises one conductive warp thread 31 and nine non-conductive warp threads 32, while each set of weft threads comprises one conductive weft thread 33 and six non-conductive weft threads 34a - 34f.

The sectors 35a, 35b are arranged adjacent one another in the warp direction *ω_{A}* and in the weft direction *ω_{E}.* In the example at issue, the plurality of sectors 35a, 35b can be considered pertaining to two different sector groups. In particular, the conductive warp thread 31 and weft thread 33 in the sectors 35a of a first sector group are woven according to a first binding scheme, while the conductive warp thread 31 and weft thread 33 in a sector 35b pertaining to the second sector group are woven according to a second binding scheme.

Moreover, the sectors 35a of the first sector group and the sectors 35b of the second sector group are arranged alternately across the warp direction *ω_{A}* and the weft direction *ω_{E}.*

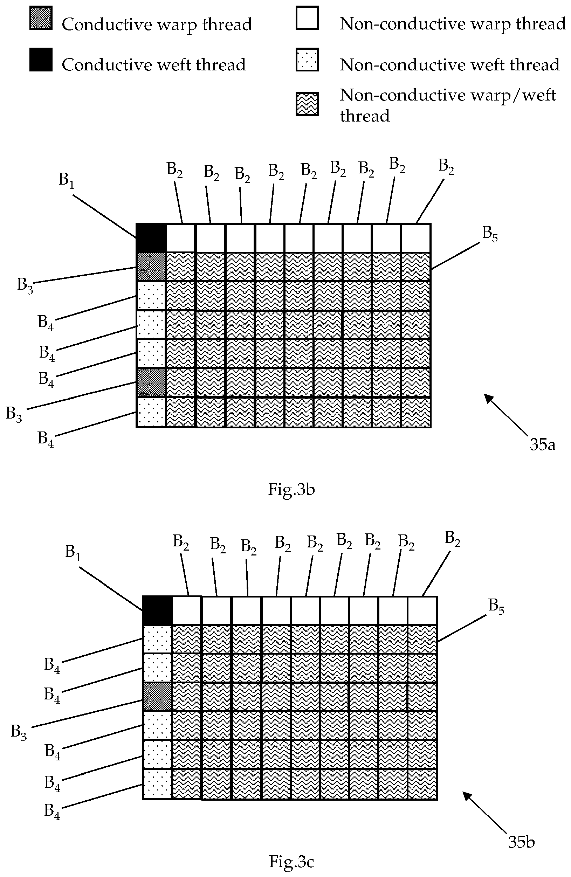

As can be best appreciated in Figure 3b, the first binding scheme comprises a single first binding point B₁ (solid black), in which the conductive warp thread 31 is lowered beneath the conductive weft thread 33. Furthermore, the first binding scheme comprises a second binding point B₂ (solid white) for each non-conductive warp thread 32, in which the non-conductive warp thread 32 is lifted above the conductive weft thread 33. Moreover, the first binding scheme comprises a first third binding point B₃ (finely dotted) in which the conductive warp thread 31 is lifted above one non-conductive weft thread 34a. Preferably, the first third binding point B₃ is adjacent to the single first binding point B₁ of the first sector 35a.

Moreover, the first binding scheme, comprises a further third binding point B₃ (finely dotted) in which the conductive warp thread 31 is lifted above one non-conductive weft thread 34e, while the conductive warp thread 31 is lowered beneath the other non-conductive weft threads 34b - 34d, and 34f in respective binding points B₄ (sparsely dotted).

In the remaining binding points B₅ (zigzag patterned), the non-conductive warp can be lifted or lowered to reproduce a desired aesthetic design on the patterned surface 10.

The second biding scheme - shown in Figure 3c - comprises a single first binding point B₁ (solid black), in which the conductive warp thread 31 is lowered beneath the weft thread 33, and a second binding point B₂ (solid white) for each non-conductive warp thread 32, in which the non-conductive warp thread 32 is lifted above the conductive weft thread 31 - as in the first scheme.

Moreover, the second binding scheme comprises a single third binding point B₃ (finely dotted) in which the conductive warp thread 31 is lifted above one non-conductive weft thread 34c, while the conductive warp thread 31 is lowered beneath the other non-conductive weft threads 34a, 34b, and 34d - 34f in respective binding points B₄ (sparsely dotted)

In the remaining binding points B₅ (zigzag patterned), the non-conductive warp threads can be lifted or lowered to reproduce a desired aesthetic design on the patterned surface 10.

As can be appreciated in Figure 3a, along the warp direction *ω_{A}* the conductive warp threads 31 are lifted above one of the weft threads 34a-34f every three or four weft threads for the whole fabric 1 length. In the example at issue, two consecutive liftings of the conductive warp threads 31 are separated apart by three weft threads 34a-34f, then the next two consecutive lifting of the conductive warp threads 31 are separated apart by four weft threads 33, 34a-34f, and this sequence is, preferably, repeated periodically along the warp direction *ω_{A}.*

The Applicant has conducted tests aimed to evaluate the electromagnetic shielding property of fabric samples according to embodiments of the present invention and comparison fabric samples having different features form the fabric according to embodiments of the present invention.

Particularly, the tests comprised the steps of irradiating electromagnetic radiations having a known power toward a sample of fabric and measuring the power of the electromagnetic radiations on the other side of the fabric sample. In particular, the sample of fabric was placed over an opening of a box made of a material impassable by the electromagnetic radiations used in the test. Inside the box, a receiver was placed behind the fabric sample, the receiver being configured to measure the power of any electromagnetic radiations inside the box. Finally, an antenna was placed at one meter from the fabric sample, without any obstacle between the antenna and the fabric sample.

### Test 1

In a first test, a first fabric sample S₁ manufactured according to an embodiment of the present invention has been used. The first fabric sample S₁ comprises conductive threads made of a blend of 95% of wool fibers and 5% of stainless-steel fibers. Particularly, both the conductive warp and weft threads have a fineness of 50/2 Nm. Moreover, the non-conductive warp threads have a fineness of 60/2 Nm and the non-conductive weft threads have a fineness of 28/2 Nm. The first fabric sample S1 comprises a conductive to non-conductive warp threads ratio of 3:1 and a conductive to non-conductive weft threads ratio of 2:1.

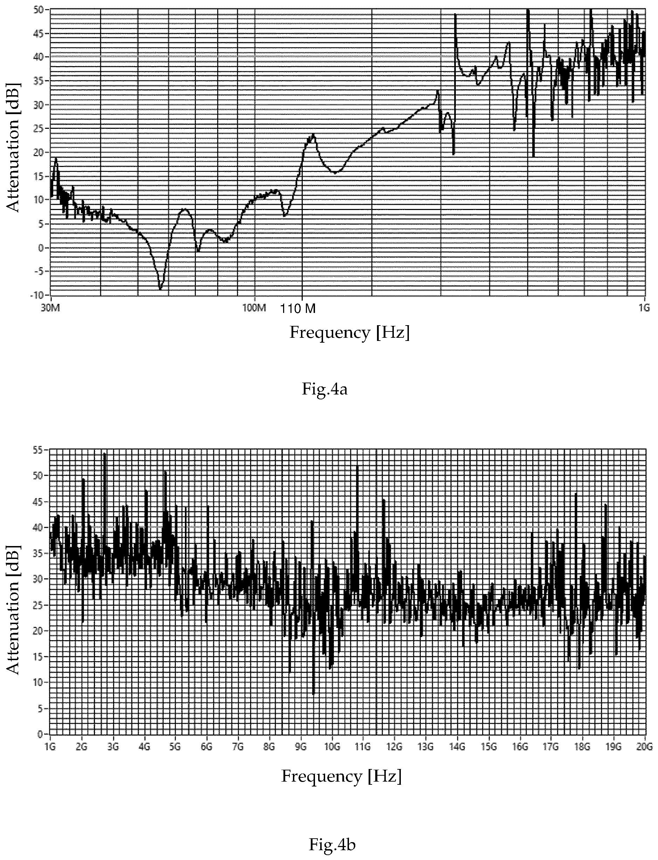

As depicted in Figure 4a and 4b, the first fabric sample S₁ offers a substantial shielding effect from electromagnetic radiations, i.e. an attenuation equal or greater than 20 dB for frequencies equal or higher than 110MHz. In detail, within the radiofrequencies range of 400 MHz to 1 GHz, the attenuation of electromagnetic radiations is equal to or higher than 40 dB in average. Moreover, within the radiofrequency range of 1 GHz - 20 GHz, the attenuation of electromagnetic radiations ranges from 25 dB to 35 dB in average.

This means that, in average, a textile made according to the first fabric sample S₁ reduces the energy associated with any incident electromagnetic radiations having a frequency ranging from 110 MHz to 20 GHz by an attenuation factor falling within the range of 100 to 10⁴. In other words, with respect to the above frequency range, the energy associated with the electromagnetic radiation measured downstream of the textile has a value ranging from 1% to 0.01% of the energy of the electromagnetic radiation upstream of the textile.

It should be noted that the overall considered radiofrequency range - i.e., ranging from 110 MHz to 20 GHz - encompasses most of the frequency bands used by wireless communication systems - in particular, this range comprises most of the frequency bands used by the GSM, UMTS, LTE/LTE-A, 5G, Wi-Fi, *etc*., standards.

Particularly, Table I shows the attenuation provided by the first fabric sample S₁ at frequencies comprised in the main frequencies bands used by cellular and WLAN networks.

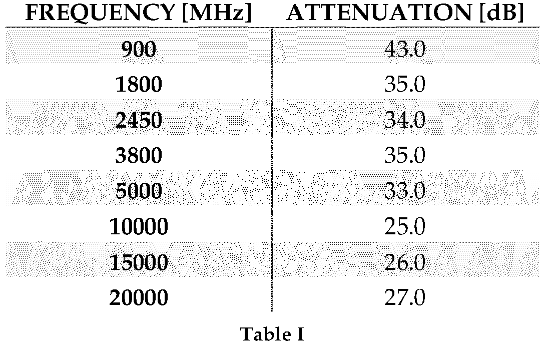

Moreover, the electromagnetic shielding properties of the first fabric sample S₁ have been tested at higher frequencies (e.g., at frequencies used by 5G networks) and the results are defined in the following Table II:

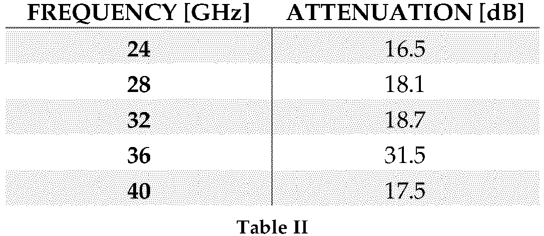

From the above, it is apparent that the first fabric sample S₁ offers a substantial attenuation (namely an attenuation by a factor of at least 50) also with respect to electromagnetic radiation generated by devices working in the frequency range 20 GHz - 40 GHz, i.e. millimeter wave (mmWave) wavelengths used by 5G.

In conclusion, textiles made according to the first fabric sample S₁ of the invention are capable of attenuating down to a negligible level (at least lower than 3%) the energy associated with electromagnetic radiations in the frequency bands used by wireless communication systems - spanning from 110 MHz to 40 GHz - thereby preventing that a harmful level of energy reaches a body covered by the textile or that useful wireless communication between opposite sides of the textile takes place.

### Comparative test 1

A second fabric sample S₂ comprises conductive threads made of a blend of 98% of wool fibers and 2% of steel fibers. Particularly, both the conductive warp and weft threads have a fineness of 50/2 Nm. Moreover, the non-conductive warp threads have a fineness of 60/2 Nm, and the non-conductive weft threads have a fineness of 28/2 Nm. The second fabric sample S₂ comprises a conductive to non-conductive warp threads ratio of 9:1, and a conductive to non-conductive weft threads ratio of 7:1.

In other words, the conductive threads used to weave the second fabric sample S₂ are made of non-conductive/conductive materials in a ratio lower than the minimum ratio according to the invention.

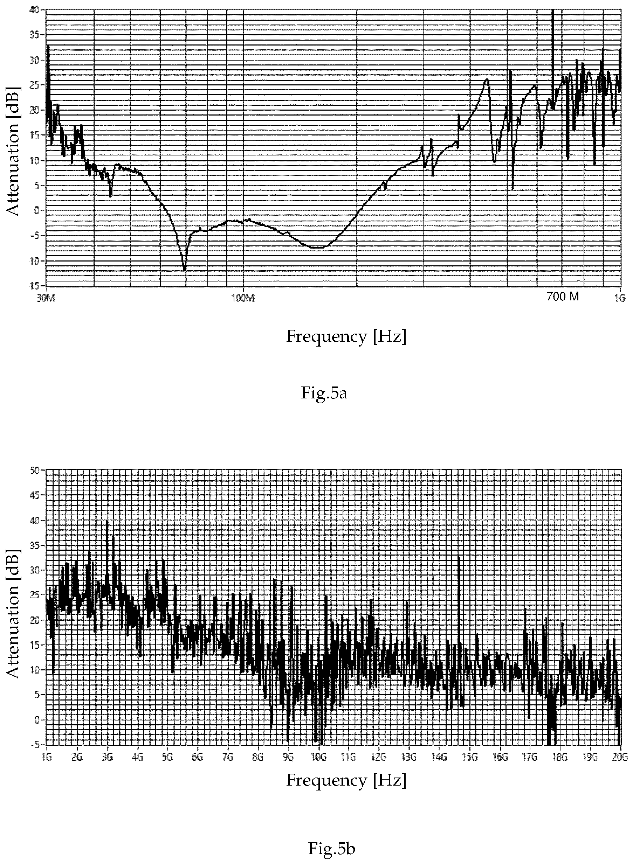

As shown in Figures 5a and 5b, the second fabric sample S₂ offers a substantially lower shielding property from electromagnetic radiations, when compared to the first S₁.

Particularly, the second fabric sample S₂ provides an attenuation that reaches its highest average value - i.e. about 25 dB - in the range of 700 MHz - 1 GHz only. Moreover, the average attenuation effect shows a decreasing trend with respect to frequencies ranging from 1 GHz to 20 GHz, by providing an average attenuation of about 25 dB with respect to the range of 1 GHz to 5 GHz, which rapidly decreases to a significantly lower average values (e.g. between 10 dB and 5 dB) for frequencies ranging from 5 GHz to 20 GHz .

Table III shows the attenuation provided by the second fabric sample S₂ at the same frequencies considered in Table I with respect to the first fabric sample S₁.

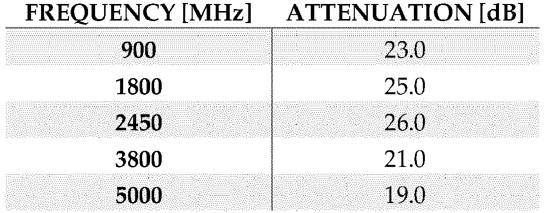

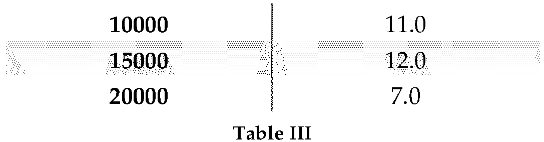

The electromagnetic shielding properties of the second fabric sample S₂ have been also tested at higher frequencies (e.g., frequencies used by 5G networks) and the results are defined in the following Table IV:

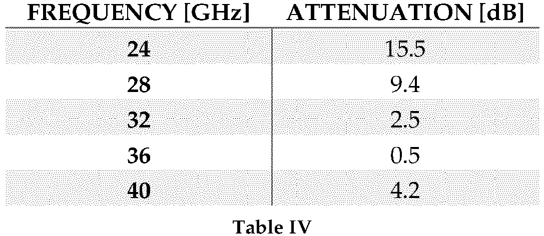

From the above, it appears that the second fabric sample S₂ has an electromagnetic shielding performance substantially lower than the first sample S₁ with respect to all the frequency ranges considered.

### Comparative test 2

A third fabric sample S₃ comprises conductive threads made of a blend of 51% of cotton-viscose (CV) fibers, 25% of wool fibers, 17% of cellulose-derived fibers (e.g., fiber with the commercial name of Tencel) and 6% of steel fibers. Particularly, both the conductive warp and weft threads have a fineness of 50/2 Nm. Moreover, the non-conductive warp threads have a fineness of 70/2 Nm and the non-conductive weft threads have a fineness of 50/2 Nm. The third fabric sample S₃ comprises a conductive to non-conductive warp threads ratio of 5:1, and a conductive to non-conductive weft threads ratio of 5:1. The third fabric sample S₃ is woven according to the teachings of the prior art and particularly of CN 105483906.

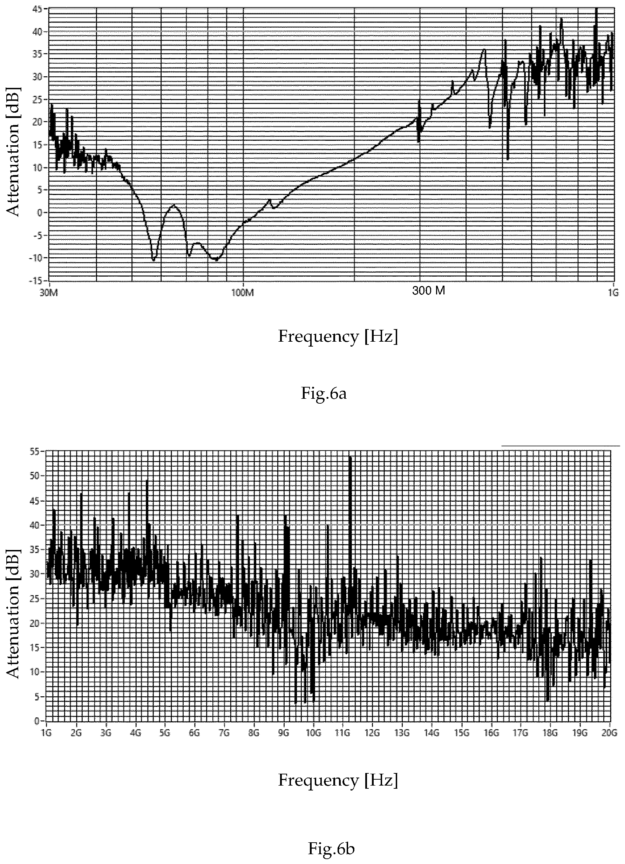

As shown in Figures 6a and 6b, the third fabric sample S₃ offers a substantially lower shielding property from electromagnetic radiations, with respect to the first S₁ sample.

Particularly, the third fabric sample S₃ provides an attenuation that reaches its highest average value - i.e. about 30 dB - in the range of 300 MHz to 1 GHz only. Moreover, the average attenuation effect shows a decreasing trend with respect to frequencies ranging from 1 GHz to 20 GHz, by providing an average attenuation of about 30 dB with respect to the range of 1 GHz to 5 GHz, which decreases to an average value lower than 20 dB and below for frequencies ranging from 8 GHz to 20 GHz.

Table V shows the attenuation values provided by the third fabric sample S₃ at the same frequencies considered in Table I with respect to the first fabric sample S₁.

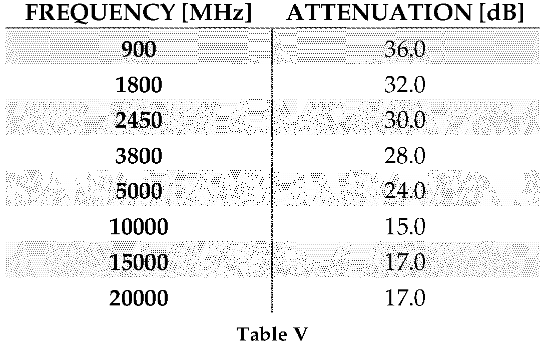

The electromagnetic shielding properties of the third fabric sample S₃ have been also tested at higher frequencies (e.g., frequencies used by 5G networks) and the results are defined in the following Table VI:

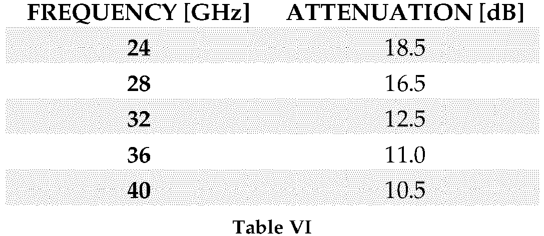

From the above, it appears that the third fabric sample S₃ has an electromagnetic shielding performance substantially lower than that of the first S₁ fabric sample. This mainly applies in the frequency range of 20 GHz - 40 GHz.

The following Table VII shows attenuation data (in dB) of the first fabric sample S₁ woven according to the present invention and of the third fabric sample S₃ at specific frequencies. As can be readily appreciated by comparing the data of Table VII, the first fabric sample S₁ according to present invention provides an overall higher and more uniform electromagnetic shielding property with respect to the third fabric sample S₃, even though the latter is made of conductive threads having a higher concentration of conductive material.

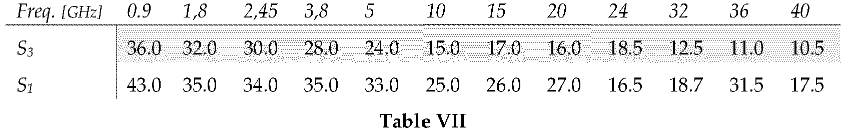

The invention, thus conceived, is susceptible of numerous modifications and variations, all of which fall within the scope of the inventive concept that characterizes the invention.

For example, in the embodiments of the invention the conductive threads are spun from stainless-steel fibers having a length ranging from 6 µm to 12 µm, preferably equal to 8 µm. Moreover, each yarn within a conductive thread is spun with a fineness having a value falling within a range of 8 Nm to 50 Nm.

In addition, in other embodiments of the invention the threads comprise different textile fibers and/or yarns. Particularly, instead of yarns comprising wool only, the conductive threads and/or the non-conductive threads are made of yarns spun from a mixture of wool and a polyamide (PA) polymer, cotton, silk and/or linen.

While the preferred ratios between conductive and non-conductive warp threads are 1:3 and 1:9 as described above, nothing prevents from implementing the invention with different ratios between conductive and non-conductive warp threads, as for example 1:2, 1:5 or 1:7 ratios.

In alternative embodiments (not shown in the drawings), nothing prevents from providing a multi-sheet fabric, comprising two or more shielding fabric sheets as described above. For example, each fabric sheet of the multi-sheet fabric is superimposed to the other fabric sheets and sewed thereto. Preferably, the fabric sheets are sewn together with the respective shielding surfaces facing inwards.

Other technically equivalent details and materials may be used, as well as the shapes and the dimensions and distances of the various components, may be any according to the requirements.

## Claims

1. An electromagnetic shielding fabric (1; 2; 3) comprising:
- a non-conductive woven layer (101), comprising a plurality of non-conductive warp threads (22; 32) and a plurality of non-conductive weft threads (24a-b, 34a-f), both the non-conductive warp threads (22; 32) and the non-conductive weft threads (24a-b, 34a-f) being made of a non-conductive material, and
- a conductive woven layer (111), comprising a plurality of conductive warp threads (21; 31) and a plurality of conductive weft threads (23; 33), both the conductive warp threads (21; 31) and the conductive weft threads (23; 33) being at least partially made of an electrically conductive material,
wherein the non-conductive woven layer (101) defines a patterned surface (10) of the fabric (1; 2; 3) and the conductive woven layer (111) defines a grid-like structure (11), the non-conductive woven layer (101) and the conductive woven layer (111) being interwoven together,
wherein the fabric (1; 2; 3) comprises a plurality of sectors (25a-b; 35a-b) arranged adjacent to one another in a warp direction and/or in a weft direction, each sector (25a-b; 35a-b) comprising at least one group of non-conductive warp threads (22; 32) and one conductive warp thread (21; 31), and at least one group of non-conductive weft threads (24a-b; 34a-f) and one conductive weft thread (23; 33), wherein the group of non-conductive warp threads (22, 32) comprises at least two non-conductive threads, and the group of non-conductive weft threads (24a-b; 34a-e) comprises at least one non-conductive thread, wherein on the patterned surface (10) of the fabric, each sector (25a-b; 35a-b) further comprises:
- a first binding point (B₁) in which the conductive warp thread (21; 31) is lowered beneath the conductive weft thread (23; 33), and **characterized in that** on the patterned surface (10) of the fabric, each sector (25a-b; 35a-b) further comprises
- a second binding point (B₂) for each non-conductive warp thread of the group of non-conductive warp threads (22; 32), in which the non-conductive warp thread (22; 32) is lifted above the conductive weft thread (23; 33),
and **in that**
alternating sectors (25a-b; 35a-b) along the warp direction and/or the weft direction comprise:
- a third binding point (B₃) in which the conductive warp thread (21; 31) is lifted above at least one non-conductive weft thread (24a; 34a) of the group of non-conductive weft threads (24a-b; 34a-f), the third binding (B₃) point being adjacent to the first binding point (B₁) in which the conductive warp thread (21; 31) is lowered beneath the conductive weft thread (23; 33).

2. The fabric (1; 2; 3) according to claim 1, wherein the group of non-conductive warp threads (22) comprises three non-conductive weft threads, and wherein alternating sectors (25a-b; 35a-b) along the warp direction and/or the weft direction comprise a single one third binding point (B₃) in which the conductive warp thread (21) is lifted above the at least one non-conductive weft thread (24a).

3. The fabric (1; 2; 3) according to claim 1, wherein the group of non-conductive weft threads (34a-f) comprises at least four non-conductive weft threads, and
wherein each sector (25a-b; 35a-b) comprises at least one further third binding point (B₃) in which the conductive warp thread (31) is lifted above the at least one non-conductive weft thread (34c, 34e), each further third binding point (B₃) being spaced apart by at least three non-conductive weft threads (34a-f) from a preceding third binding point (B₃) along the warp direction.

4. The fabric (1; 2; 3) according to any one of the preceding claims, wherein each first binding point (B₁) is spaced apart from the first binding point (B₁) of another sector (25a-b; 35a-b) by a distance ranging from 1.5 mm to 3.5 mm, preferably equal to 2 mm, in the weft direction and/or the warp direction, preferably in both the weft and the warp direction.

5. The fabric (1; 2; 3) according to any one of the preceding claims, wherein each sector (25a-b; 35a-b) comprises conductive warp threads (21; 31) and non-conductive warp threads (22, 32) in a ratio selected among: 1:3; 1:5,1:7, and 1:9.

6. The fabric (1; 2; 3) according to any one of the preceding claims, wherein the conductive warp threads (21; 31) and the conductive weft threads (23; 33) are made of yarns obtained by spinning metal fibers, preferably stainless-steel fibers, and a natural fiber, preferably wool fibers, in a ratio ranging from 5% to 50% of metal fiber, preferably equal to 20% of metal fibers.

7. The fabric (1; 2; 3) according to claim 6, wherein the conductive warp threads (21; 31) and the conductive weft threads (23; 33) have a yarn count ranging from 12.5 g/km to 125 g/km.

8. The fabric (1; 2; 3) according to claim 6 or 7, wherein the conductive warp threads (21; 31) and the conductive weft threads (23; 33) are made of yarns having a fineness ranging from 8 m/g to 50 m/g, preferably each of the conductive warp threads (21; 31) and each of the conductive weft threads (23; 33) comprises two yarns having a fineness equal to 50 m/g.

9. The fabric (1; 2; 3) according to any one of the preceding claims, wherein the non-conductive warp threads (22; 32) are made of wool and each non-conductive warp thread (22; 32) comprises two yarns having a fineness equal to 60m/ g, and the non-conductive weft threads (24a-b; 34a-f) are made of wool and each non-conductive weft thread (24a-b; 34a-f) comprises two yarns having a fineness equal to 28 m/g.

10. A multilayered fabric comprising at least two pieces of fabrics (1; 2; 3) according to any one of the previous claims, wherein two pieces of fabrics (1; 2; 3) are sewn together.

11. A method of manufacturing an electromagnetic shielding fabric (1; 2; 3), wherein the electromagnetic shielding fabric (1; 2; 3) comprises:
- a non-conductive woven layer (101), comprising a plurality of non-conductive warp threads (22; 32) and a plurality of non-conductive weft threads (24a-b, 34a-f), both the non-conductive warp threads (22; 32) and the non-conductive weft threads (24a-b, 34a-f) being made of a non-conductive material, and
- a conductive woven layer (111), comprising a plurality of conductive warp threads (21; 31) and a plurality of conductive weft threads (23; 33), both the conductive warp threads (21; 31) and the conductive weft threads (23; 33) being at least partially made of an electrically conductive material,
wherein the non-conductive woven layer (101) defines a patterned surface (10) of the fabric (1; 2; 3) and the conductive woven layer (111) defines a grid-like structure (11), the non-conductive woven layer (101) and the conductive woven layer (111) being interwoven together,
the method comprising the step of weaving the fabric (1; 2; 3) by defining a plurality of sectors (25a-b; 35a-b) arranged adjacent one another in a warp direction and/or in a weft direction, each sector (25a-b; 35a-b) comprising at least one group of non-conductive warp threads (22; 32) and one conductive warp thread (21; 31), and at least one group of non-conductive weft threads (24a-b; 34a-f) and one conductive weft thread (23; 33),
wherein the group of non-conductive warp threads (22, 32) comprises of at least two non-conductive threads, and the group of non-conductive weft threads (24a-b; 34a-e) comprises at least one non-conductive thread,
**characterized in that**
the step of weaving the fabric (1; 2; 3) by defining a plurality of sectors (25a-b; 35a-b) comprises:
- lowering the conductive warp thread (21; 31) beneath the conductive weft thread (23; 33) at a first binding point (B₁), and
- lifting each non-conductive warp thread of the group of non-conductive warp threads (22; 32) above the conductive weft thread (23; 33) at respective second binding points (B₂),
and, in alternating sectors (25a-b; 35a-b) along the warp direction and/ or the weft direction:
- lifting the conductive warp thread (21; 31) above at least one non-conductive weft thread (24a; 34a) of the group of non-conductive weft threads (24a-b; 34a-f) at a third binding point (B₃), the third binding point (B₃) being weaved adjacent to the first binding point (B₁).

12. The method according to claim 11, wherein the group of non-conductive warp threads (22) comprises three non-conductive weft threads, and
wherein lifting the conductive warp thread (21; 31) above at least one non-conductive weft thread (24a; 34a) of the group of non-conductive weft threads (24a-b; 34a-f) at a third binding point (B₃) comprises lifting the conductive warp thread (21; 31) in a single third binding point (B₃) in each sector (25a-b; 35a-b).

13. The method according to claim 11, wherein the group of non-conductive weft threads (34a-f) comprises at least four non-conductive weft threads, and
wherein lifting the conductive warp thread (21; 31) above at least one non-conductive weft thread (24a; 34a) of the group of non-conductive weft threads (24a-b; 34a-f) at a third binding point (B₃) comprises lifting the conductive warp thread (21; 31) above a plurality of non-conductive weft thread (24a; 34a) at respective third binding points (B₃), each third binding point (B₃) being spaced apart by at least three non-conductive weft threads (34a-f) from a preceding third binding point (B₃) along the warp direction.

## Patentansprüche

1. Ein elektromagnetisch abschirmendes Gewebe (1; 2; 3), umfassend:
- eine nichtleitende gewebte Schicht (101), die eine Vielzahl von nichtleitenden Kettfäden (22; 32) und eine Vielzahl von nichtleitenden Schussfäden (24a-b, 34a-f) umfasst, wobei sowohl die nichtleitenden Kettfäden (22; 32) als auch die nichtleitenden Schussfäden (24a-b, 34a-f) aus einem nichtleitenden Material sind, und
- eine leitende gewebte Schicht (111), die eine Vielzahl von leitenden Kettfäden (21; 31) und eine Vielzahl von leitenden Schussfäden (23; 33) umfasst, wobei sowohl die leitenden Kettfäden (21; 31) als auch die leitenden Schussfäden (23; 33) zumindest teilweise aus einem elektrisch leitenden Material sind,
wobei die nichtleitende gewebte Schicht (101) eine gemusterte Oberfläche (10) des Gewebes (1; 2; 3) definiert und die leitende gewebte Schicht (111) eine gitterartige Struktur (11) definiert, wobei die nichtleitende gewebte Schicht (101) und die leitende gewebte Schicht (111) miteinander verwoben sind,
wobei das Gewebe (1; 2; 3) eine Vielzahl von Sektoren (25a-b; 35a-b) umfasst, die in einer Kettrichtung und/oder in einer Schussrichtung nebeneinander angeordnet sind, wobei jeder Sektor (25a-b; 35a-b) mindestens eine Gruppe von nichtleitenden Kettfäden (22; 32) und einen leitenden Kettfaden (21; 31) und mindestens eine Gruppe von nichtleitenden Schussfäden (24a-b; 34a-f) und einen leitenden Schussfaden (23; 33) umfasst,
wobei die Gruppe der nichtleitenden Kettfäden (22, 32) mindestens zwei nichtleitende Fäden umfasst und die Gruppe der nichtleitenden Schussfäden (24a-b; 34a-e) mindestens einen nichtleitenden Faden umfasst,
wobei auf der gemusterten Oberfläche (10) des Gewebes jeder Sektor (25ab; 35a-b) ferner umfasst:
- einen ersten Bindungspunkt (B₁), in dem der leitende Kettfaden (21; 31) unter den leitenden Schussfaden (23; 33) abgesenkt ist, und **dadurch gekennzeichnet, dass** auf der gemusterten Oberfläche (10) des Gewebes jeder Sektor (25a-b; 35a-b) ferner umfasst:
- einen zweiten Bindungspunkt (B₂) für jeden nichtleitenden Kettfaden der Gruppe der nichtleitenden Kettfäden (22; 32), in dem der nichtleitende Kettfaden (22; 32) über den leitenden Schussfaden (23; 33) angehoben ist,
und dass
abwechselnde Sektoren (25a-b; 35a-b) entlang der Kettrichtung und/oder der Schussrichtung umfassen:
- einen dritten Bindungspunkt (B₃), in dem der leitende Kettfaden (21; 31) über mindestens einen nichtleitenden Schussfaden (24a; 34a) der Gruppe der nichtleitenden Schussfäden (24a-b; 34a-f) angehoben ist, wobei der dritte Bindungspunkt (B₃) neben dem ersten Bindungspunkt (B₁) ist, in dem der leitende Kettfaden (21; 31) unter den leitenden Schussfaden (23; 33) abgesenkt ist.

2. Gewebe (1; 2; 3) gemäß Anspruch 1, wobei die Gruppe der nichtleitenden Kettfäden (22) drei nichtleitende Schussfäden umfasst, und wobei abwechselnde Sektoren (25ab; 35a-b) entlang der Kettrichtung und/oder der Schussrichtung einen einzigen, dritten Bindungspunkt (B₃) umfassen, in dem der leitende Kettfaden (21) über den mindestens einen nichtleitenden Schussfaden (24a) angehoben ist.

3. Gewebe (1; 2; 3) gemäß Anspruch 1, wobei die Gruppe der nichtleitenden Schussfäden (34a-f) mindestens vier nichtleitende Schussfäden umfasst, und
wobei jeder Sektor (25a-b; 35a-b) mindestens einen weiteren dritten Bindungspunkt (B₃) umfasst, in dem der leitende Kettfaden (31) über den mindestens einen nichtleitenden Schussfaden (34c, 34e) angehoben ist, wobei jeder weitere dritte Bindungspunkt (B₃) um mindestens drei nichtleitende Schussfäden (34a-f) von einem vorhergehenden dritten Bindungspunkt (B₃) entlang der Kettrichtung beabstandet ist.

4. Gewebe (1; 2; 3) gemäß einem der vorhergehenden Ansprüche, wobei jeder erste Bindungspunkt (B₁) von dem ersten Bindungspunkt (B₁) eines anderen Sektors (25a-b; 35a-b) in Schussrichtung und/oder Kettrichtung, bevorzugt sowohl in Schussrichtung als auch in Kettrichtung, um einen Abstand von 1,5 mm bis 3,5 mm, bevorzugt gleich 2 mm, beabstandet ist.

5. Gewebe (1; 2; 3) gemäß einem der vorhergehenden Ansprüche, wobei jeder Sektor (25a-b; 35a-b) leitende Kettfäden (21; 31) und nichtleitende Kettfäden (22, 32) in einem Verhältnis umfasst, ausgewählt aus: 1:3; 1:5, 1:7, und 1:9.

6. Gewebe (1; 2; 3) gemäß einem der vorhergehenden Ansprüche, wobei die leitenden Kettfäden (21; 31) und die leitenden Schussfäden (23; 33) aus Garnen sind, die durch Verspinnen von Metallfasern, bevorzugt Edelstahlfasern, und einer natürlichen Faser, bevorzugt Wollfasern, in einem Verhältnis von 5 % bis 50 % Metallfasern, bevorzugt gleich 20 % Metallfasern, erhalten werden.

7. Gewebe (1; 2; 3) gemäß Anspruch 6, wobei die leitenden Kettfäden (21; 31) und die leitenden Schussfäden (23; 33) eine Garnnummer im Bereich von 12,5 g/km bis 125 g/km aufweisen.

8. Gewebe (1; 2; 3) gemäß Anspruch 6 oder 7, wobei die leitenden Kettfäden (21; 31) und die leitenden Schussfäden (23; 33) aus Garnen sind, die eine Feinheit im Bereich von 8 m/g bis 50 m/g aufweisen, wobei bevorzugt jeder der leitenden Kettfäden (21; 31) und jeder der leitenden Schussfäden (23; 33) zwei Garne umfasst, die eine Feinheit gleich 50 m/g aufweisen.

9. Gewebe (1; 2; 3) gemäß einem der vorhergehenden Ansprüche, wobei die nichtleitenden Kettfäden (22; 32) aus Wolle sind und jeder nichtleitende Kettfaden (22; 32) zwei Garne umfasst, die eine Feinheit gleich 60 m/g aufweisen, und die nichtleitenden Schussfäden (24a-b; 34a-f) aus Wolle sind und jeder nichtleitende Schussfaden (24a-b; 34a-f) zwei Garne umfasst, die eine Feinheit gleich 28 m/g aufweisen.

10. Mehrschichtiges Gewebe, umfassend mindestens zwei Stücke eines Gewebes (1; 2; 3) gemäß einem der vorhergehenden Ansprüche, wobei die zwei Stücke des Gewebes (1; 2; 3) miteinander vernäht sind.

11. Verfahren zum Herstellen eines elektromagnetisch abschirmenden Gewebes (1; 2; 3), wobei das elektromagnetisch abschirmende Gewebe (1; 2; 3) umfasst:
- eine nichtleitende gewebte Schicht (101), die eine Vielzahl von nichtleitenden Kettfäden (22; 32) und eine Vielzahl von nichtleitenden Schussfäden (24a-b, 34a-f) umfasst, wobei sowohl die nichtleitenden Kettfäden (22; 32) als auch die nichtleitenden Schussfäden (24a-b, 34a-f) aus einem nichtleitenden Material sind, und
- eine leitende gewebte Schicht (111), die eine Vielzahl von leitenden Kettfäden (21; 31) und eine Vielzahl von leitenden Schussfäden (23; 33) umfasst, wobei sowohl die leitenden Kettfäden (21; 31) als auch die leitenden Schussfäden (23; 33) zumindest teilweise aus einem elektrisch leitenden Material sind,
wobei die nichtleitende gewebte Schicht (101) eine gemusterte Oberfläche (10) des Gewebes (1; 2; 3) definiert und die leitende gewebte Schicht (111) eine gitterartige Struktur (11) definiert, wobei die nichtleitende gewebte Schicht (101) und die leitende gewebte Schicht (111) miteinander verwoben sind,
wobei das Verfahren den Schritt des Webens des Gewebes (1; 2; 3) durch Definieren einer Vielzahl von Sektoren (25a-b; 35a-b) umfasst, die in einer Kettrichtung und/oder in einer Schussrichtung nebeneinander angeordnet sind, wobei jeder Sektor (25a-b; 35a-b) mindestens eine Gruppe von nichtleitenden Kettfäden (22; 32) und einen leitenden Kettfaden (21; 31) und mindestens eine Gruppe von nichtleitenden Schussfäden (24a-b; 34a-f) und einen leitenden Schussfaden (23; 33) umfasst,
wobei die Gruppe der nichtleitenden Kettfäden (22, 32) mindestens zwei nichtleitende Fäden umfasst und die Gruppe der nichtleitenden Schussfäden (24a-b; 34a-e) mindestens einen nichtleitenden Faden umfasst,
**dadurch gekennzeichnet, dass**
der Schritt des Webens des Gewebes (1; 2; 3) durch Definieren einer Vielzahl von Sektoren (25a-b; 35a-b) umfasst:
- Absenken des leitenden Kettfadens (21; 31) unter den leitenden Schussfaden (23; 33) an einem ersten Bindepunkt (B₁), und
- Anheben jedes nichtleitenden Kettfadens der Gruppe der nichtleitenden Kettfäden (22; 32) über den leitenden Schussfaden (23; 33) an den jeweiligen zweiten Bindungspunkten (B₂),
und in abwechselnden Sektoren (25a-b; 35a-b) entlang der Kettrichtung und/oder der Schussrichtung:
- Anheben des leitenden Kettfadens (21; 31) über mindestens einen nichtleitenden Schussfaden (24a; 34a) der Gruppe der nichtleitenden Schussfäden (24a-b; 34a-f) an einem dritten Bindungspunkt (B₃), wobei der dritte Bindungspunkt (B₃) neben dem ersten Bindungspunkt (B₁) gewebt wird.

12. Verfahren gemäß Anspruch 11, wobei die Gruppe der nichtleitenden Kettfäden (22) drei nichtleitende Schussfäden umfasst, und
wobei das Anheben des leitenden Kettfadens (21; 31) über mindestens einen nichtleitenden Schussfaden (24a; 34a) der Gruppe der nichtleitenden Schussfäden (24a-b; 34a-f) an einem dritten Bindungspunkt (B₃) das Anheben des leitenden Kettfadens (21; 31) in einem einzigen dritten Bindungspunkt (B₃) in jedem Sektor (25ab; 35a-b) umfasst.

13. Verfahren gemäß Anspruch 11, wobei die Gruppe der nichtleitenden Schussfäden (34a-f) mindestens vier nichtleitende Schussfäden umfasst, und
wobei das Anheben des leitenden Kettfadens (21; 31) über mindestens einen nichtleitenden Schussfaden (24a; 34a) der Gruppe der nichtleitenden Schussfäden (24a-b; 34a-f) an einem dritten Bindungspunkt (B₃) das Anheben des leitenden Kettfadens (21; 31) über eine Vielzahl von nichtleitenden Schussfäden (24a; 34a) an jeweiligen dritten Bindungspunkten (B₃) umfasst, wobei jeder dritte Bindungspunkt (B₃ ) um mindestens drei nichtleitende Schussfäden (34a-f) von einem vorhergehenden dritten Bindungspunkt (B₃) entlang der Kettrichtung beabstandet ist.

## Revendications

1. - Tissu de blindage électromagnétique (1 ; 2 ; 3) comprenant :
- une couche tissée non-conductrice (101), comprenant une pluralité de fils de chaîne non-conducteurs (22 ; 32) et une pluralité de fils de trame non-conducteurs (24a-b, 34a-f), les fils de chaîne non-conducteurs (22 ; 32) et les fils de trame non-conducteurs (24a-b, 34a-f) étant faits d'un matériau non-conducteur, et
- une couche tissée conductrice (111), comprenant une pluralité de fils de chaîne conducteurs (21 ; 31) et une pluralité de fils de trame conducteurs (23 ; 33), les fils de chaîne conducteurs (21 ; 31) et les fils de trame conducteurs (23 ; 33) étant au moins partiellement faits d'un matériau conduisant l'électricité,
la couche tissée non-conductrice (101) définissant une surface à motifs (10) du tissu (1 ; 2 ; 3) et la couche tissée conductrice (111) définissant une structure en forme de grille (11), la couche tissée non-conductrice (101) et la couche tissée conductrice (111) étant entrelacées ensemble,
le tissu (1 ; 2 ; 3) comprenant une pluralité de secteurs (25a-b; 35a-b) disposés adjacents les uns aux autres dans un sens de chaîne et/ou dans un sens de trame, chaque secteur (25a-b ; 35a-b) comprenant au moins un groupe de fils de chaîne non-conducteurs (22 ; 32) et un fil de chaîne conducteur (21 ; 31), et au moins un groupe de fils de trame non-conducteurs (24a-b ; 34a-f) et un fil de trame conducteur (23 ; 33),
le groupe de fils de chaîne non-conducteurs (22, 32) comprenant au moins deux fils non-conducteurs, et le groupe de fils de trame non-conducteurs (24a-b ; 34a-e) comprenant au moins un fil non-conducteur,
sur la surface à motifs (10) du tissu, chaque secteur (25a-b ; 35a-b) comprenant en outre :
- un premier point de liaison (B1) dans lequel le fil de chaîne conducteur (21 ; 31) est abaissé sous le fil de trame conducteur (23 ; 33), et
**caractérisé par le fait que**, sur la surface à motifs (10) du tissu, chaque secteur (25a-b ; 35a-b) comprend en outre :
- un deuxième point de liaison (B2) pour chaque fil de chaîne non-conducteur du groupe de fils de chaîne non-conducteurs (22 ; 32), dans lequel le fil de chaîne non-conducteur (22 ; 32) est soulevé au-dessus du fil de trame conducteur (23 ; 33),
et **par le fait que**
des secteurs alternés (25a-b ; 35a-b) le long du sens de chaîne et/ou du sens de trame comprennent :
- un troisième point de liaison (B3) dans lequel le fil de chaîne conducteur (21 ; 31) est soulevé au-dessus d'au moins un fil de trame non-conducteur (24a ; 34a) du groupe de fils de trame non-conducteurs (24a-b ; 34a-f), le troisième point de liaison (B3) étant adjacent au premier point de liaison (B1) dans lequel le fil de chaîne conducteur (21 ; 31) est abaissé sous le fil de trame conducteur (23 ; 33).

2. - Tissu (1 ; 2 ; 3) selon la revendication 1, dans lequel le groupe de fils de chaîne non-conducteurs (22) comprend trois fils de trame non-conducteurs, et dans lequel des secteurs alternés (25a-b ; 35a-b) le long du sens de chaîne et/ou du sens de trame comprennent un seul troisième point de liaison (B3) dans lequel le fil de chaîne conducteur (21) est soulevé au-dessus de l'au moins un fil de trame non-conducteur (24a).

3. - Tissu (1 ; 2 ; 3) selon la revendication 1, dans lequel le groupe de fils de trame non-conducteurs (34a-f) comprend au moins quatre fils de trame non-conducteurs, et
dans lequel chaque secteur (25a-b ; 35a-b) comprend au moins un troisième point de liaison supplémentaire (B3) dans lequel le fil de chaîne conducteur (31) est soulevé au-dessus de l'au moins un fil de trame non-conducteur (34c, 34e), chaque troisième point de liaison supplémentaire (B3) étant espacé d'au moins trois fils de trame non-conducteurs (34a-f) par rapport à un troisième point de liaison précédent (B3) le long du sens de chaîne.

4. - Tissu (1 ; 2 ; 3) selon l'une quelconque des revendications précédentes, dans lequel chaque premier point de liaison (B1) est espacé du premier point de liaison (B1) d'un autre secteur (25a-b ; 35a-b) d'une distance située dans une plage allant de 1,5 mm à 3,5 mm, de préférence égale à 2 mm, dans le sens de trame et/ou dans le sens de chaîne, de préférence à la fois dans le sens de trame et dans le sens de chaîne.

5. - Tissu (1 ; 2 ; 3) selon l'une quelconque des revendications précédentes, dans lequel chaque secteur (25a-b ; 35a-b) comprend des fils de chaîne conducteurs (21 ; 31) et des fils de chaîne non-conducteurs (22, 32) dans un rapport choisi parmi : 1:3 ; 1:5, 1:7 et 1:9.

6. - Tissu (1 ; 2 ; 3) selon l'une quelconque des revendications précédentes, dans lequel les fils de chaîne conducteurs (21 ; 31) et les fils de trame conducteurs (23 ; 33) sont faits de fils obtenus par filage de fibres métalliques, de préférence de fibres d'acier inoxydable, et d'une fibre naturelle, de préférence des fibres de laine, dans un rapport se situant dans la plage allant de 5% à 50% de fibres métalliques, de préférence égal à 20% de fibres métalliques.

7. - Tissu (1 ; 2 ; 3) selon la revendication 6, dans lequel les fils de chaîne conducteurs (21 ; 31) et les fils de trame conducteurs (23 ; 33) ont un titrage se situant dans la plage allant de 12,5 g/km à 125 g/km.

8. - Tissu (1 ; 2 ; 3) selon la revendication 6 ou 7, dans lequel les fils de chaîne conducteurs (21 ; 31) et les fils de trame conducteurs (23 ; 33) sont faits de fils ayant une finesse se situant dans la plage allant de 8 m/g à 50 m/g, de préférence chacun des fils de chaîne conducteurs (21 ; 31) et chacun des fils de trame conducteurs (23 ; 33) comprend deux fils ayant une finesse égale à 50 m/g.

9. - Tissu (1 ; 2 ; 3) selon l'une quelconque des revendications précédentes, dans lequel les fils de chaîne non-conducteurs (22 ; 32) sont faits de laine et chaque fil de chaîne non-conducteur (22 ; 32) comprend deux fils ayant une finesse égale à 60 m/g, et les fils de trame non-conducteurs (24a-b ; 34a-f) sont faits de laine et chaque fil de trame non-conducteur (24a-b ; 34a-f) comprend deux fils ayant une finesse égale à 28 m/g.

10. - Tissu multicouche comprenant au moins deux pièces de tissus (1 ; 2 ; 3) selon l'une quelconque des revendications précédentes, dans lequel deux pièces de tissus (1 ; 2 ; 3) sont cousues ensemble.

11. - Procédé de fabrication d'un tissu de blindage électromagnétique (1 ; 2 ; 3), dans lequel le tissu de blindage électromagnétique (1 ; 2 ; 3) comprend :
- une couche tissée non-conductrice (101), comprenant une pluralité de fils de chaîne non-conducteurs (22 ; 32) et une pluralité de fils de trame non-conducteurs (24a-b, 34a-f), les fils de chaîne non-conducteurs (22 ; 32) et les fils de trame non-conducteurs (24a-b, 34a-f) étant faits d'un matériau non-conducteur, et
- une couche tissée conductrice (111), comprenant une pluralité de fils de chaîne conducteurs (21 ; 31) et une pluralité de fils de trame conducteurs (23 ; 33), les fils de chaîne conducteurs (21 ; 31) et les fils de trame conducteurs (23 ; 33) étant au moins partiellement faits d'un matériau conduisant l'électricité,
la couche tissée non-conductrice (101) définissant une surface à motifs (10) du tissu (1 ; 2 ; 3) et la couche tissée conductrice (111) définissant une structure en forme de grille (11), la couche tissée non-conductrice (101) et la couche tissée conductrice (111) étant entrelacées ensemble,
le procédé comprenant l'étape de tissage du tissu (1 ; 2 ; 3) en définissant une pluralité de secteurs (25a-b ; 35a-b) disposés adjacents les uns aux autres dans un sens de chaîne et/ou dans un sens de trame, chaque secteur (25a-b ; 35a-b) comprenant au moins un groupe de fils de chaîne non-conducteurs (22 ; 32) et un fil de chaîne conducteur (21 ; 31), et au moins un groupe de fils de trame non-conducteurs (24a-b ; 34a-f) et un fil de trame conducteur (23 ; 33),
le groupe de fils de chaîne non-conducteurs (22, 32) comprenant au moins deux fils non-conducteurs, et le groupe de fils de trame non-conducteurs (24a-b ; 34a-e) comprenant au moins un fil non conducteur,
**caractérisé par le fait que**
l'étape de tissage du tissu (1 ; 2 ; 3) définissant une pluralité de secteurs (25a-b ; 35a-b) comprend :
- abaisser le fil de chaîne conducteur (21 ; 31) sous le fil de trame conducteur (23 ; 33) à un premier point de liaison (B1), et
- soulever chaque fil de chaîne non-conducteur du groupe de fils de chaîne non-conducteurs (22 ; 32) au-dessus du fil de trame conducteur (23 ; 33) à des deuxièmes points de liaison respectifs (B2), et
dans des secteurs alternés (25a-b ; 35a-b) le long du sens de chaîne et/ou du sens de trame :
- soulever le fil de chaîne conducteur (21 ; 31) au-dessus d'au moins un fil de trame non-conducteur (24a ; 34a) du groupe de fils de trame non-conducteurs (24a-b ; 34a-f) à un troisième point de liaison (B3), le troisième point de liaison (B3) étant tissé adjacent au premier point de liaison (B1).

12. - Procédé selon la revendication 11, dans lequel le groupe de fils de chaîne non-conducteurs (22) comprend trois fils de trame non-conducteurs, et
dans lequel soulever le fil de chaîne conducteur (21 ; 31) au-dessus d'au moins un fil de trame non-conducteur (24a ; 34a) du groupe de fils de trame non-conducteurs (24a-b ; 34a-f) à un troisième point de liaison (B3) comprend soulever le fil de chaîne conducteur (21 ; 31) à un seul troisième point de liaison (B3) dans chaque secteur (25a-b ; 35a-b).

13. - Procédé selon la revendication 11, dans lequel le groupe de fils de trame non-conducteurs (34a-f) comprend au moins quatre fils de trame non-conducteurs, et
dans lequel soulever le fil de chaîne conducteur (21 ; 31) au-dessus d'au moins un fil de trame non-conducteur (24a ; 34a) du groupe de fils de trame non-conducteurs (24a-b ; 34a-f) à un troisième point de liaison (B3) comprend soulever le fil de chaîne conducteur (21 ; 31) au-dessus d'une pluralité de fils de trame non-conducteurs (24a ; 34a) à des troisièmes points de liaison respectifs (B3), chaque troisième point de liaison (B3) étant espacé d'au moins trois fils de trame non-conducteurs (34a-f) par rapport au troisième point de liaison précédent (B3) le long du sens de chaîne.
